# FASCICULE DE BREVET EUROPEEN

(11) **EP 3 150 425 B1**
(45) Date de publication et mention de la délivrance du brevet: **04.12.2019**
(21) Numéro de dépôt: 16191298.5
(22) Date de dépôt: 29.09.2016
(51) Int. Cl.: B60M 3/00, B60M 1/18, B60M 1/22, G01R 31/02, G05B 9/02, G05B 11/01, H04B 3/54, H02G 7/00

(54) **SYSTÈME AMÉLIORÉ D'ALIMENTATION D'UNE LIGNE AÉRIENNE DE CONTACT**
VERBESSERTES STROMVERSORGUNGSSYSTEM EINER KONTAKT-FREILEITUNG
IMPROVED POWER SUPPLY SYSTEM FOR AN OVERHEAD CONTACT LINE

(30) Priorité: 30.09.2015 FR 1559296
(43) Date de publication de la demande: 05.04.2017
(73) Titulaire: ALSTOM Transport Technologies, 93400 Saint-Ouen (FR)
(72) Inventeur: FLAMANC, Emmanuel, 78390 BOIS D'ARCY (FR); AUTHIE, Pierre, 78750 MAREIL MARLY (FR)
(74) Mandataire: Lavoix

(56) Documents cités:
- EP-A1- 1 193 109
- EP-A1- 1 550 575
- CN-U- 204 184 214
- JP-A- H0 616 070

## Description

La présente invention concerne les systèmes d'alimentation pour les lignes aérienne de contact.

Une ligne aérienne d'alimentation électrique d'un véhicule est appelée ligne aérienne de contact lorsqu'elle ne comporte qu'un ou deux fils de contact. Ceux-ci sont directement maintenus, à intervalles réguliers, par des potences de manière à être sensiblement horizontaux.

Une ligne aérienne d'alimentation électrique est appelée caténaire lorsqu'elle est constituée d'un ou deux fils de contact suspendus par des pendules à un ou deux câbles porteurs. Le câble porteur est lui-même maintenus, à intervalles réguliers, par des potences. Le câble porteur, sous l'effet de son propre poids, prend la forme une chaînette et les pendules ont des hauteurs adaptées de manière à ce que le fils de contact soit suspendu sensiblement horizontalement.

Le véhicule électrique est alors alimenté par captage du courant circulant sur le fil de contact au moyen d'un pantographe monté sur la toiture du véhicule et déployé pour venir en contact du fil de contact.

Dans le présent document, par véhicule électrique, on entend tous véhicules propres à capter du courant sur une telle ligne aérienne de contact. Il s'agit par exemple d'un véhicule électrique guidé (train, tramway, etc.) ou d'un véhicule non guidé (trolleybus, voiture, etc.)

La rupture du fil de contact d'une ligne aérienne de contact est un accident dangereux, qui survient notamment aux passages à niveau ou par fusion au niveau du pantographe d'un train arrêté.

Or, une fois rompu, le fil de contact pend ou tombe au sol. Etant porté à une potentiel élevé, il présente alors un risque important d'électrocution pour les personnes se trouvant dans la zone avoisinant le point de rupture.

Le document EP 1 550 575 A1 divulgue un système d'alimentation conforme au préambule de la revendication 1.

Le document CN 204 184 214 U divulgue un système d'alimentation comportant un interrupteur de contournement d'une sous-station d'alimentation permettant de connecter directement entre elles les sections normalement connectées par l'intermédiaire de la sous-station d'alimentation contournée.

L'invention a donc pour but de palier à ce problème.

A cet effet, l'invention a pour objet un système d'alimentation conforme aux revendications.

L'invention sera mieux comprise à l'aide de la description qui va suivre, donnée uniquement à titre d'exemple non limitatif, et faite en se référant aux dessins annexés sur lesquels :
- la figure 1 est une représentation schématique d'un premier mode de réalisation d'un système d'alimentation pour une ligne aérienne de contact comportant un unique fil de contact, dans un état dans lequel le fil de contact est intègre ;
- la figure 2 est similaire à la figure 1, le système étant dans un état dans lequel le fil de contact est rompu ;
- la figure 3 est une représentation schématique d'un second mode de réalisation d'un système d'alimentation, dans lequel une sous-station d'alimentation peut être contournée en cas de dysfonctionnement ; et,
- la figure 4 est une représentation schématique d'un troisième mode de réalisation d'un système d'alimentation, pour une ligne aérienne de contact comportant deux fils de contact.

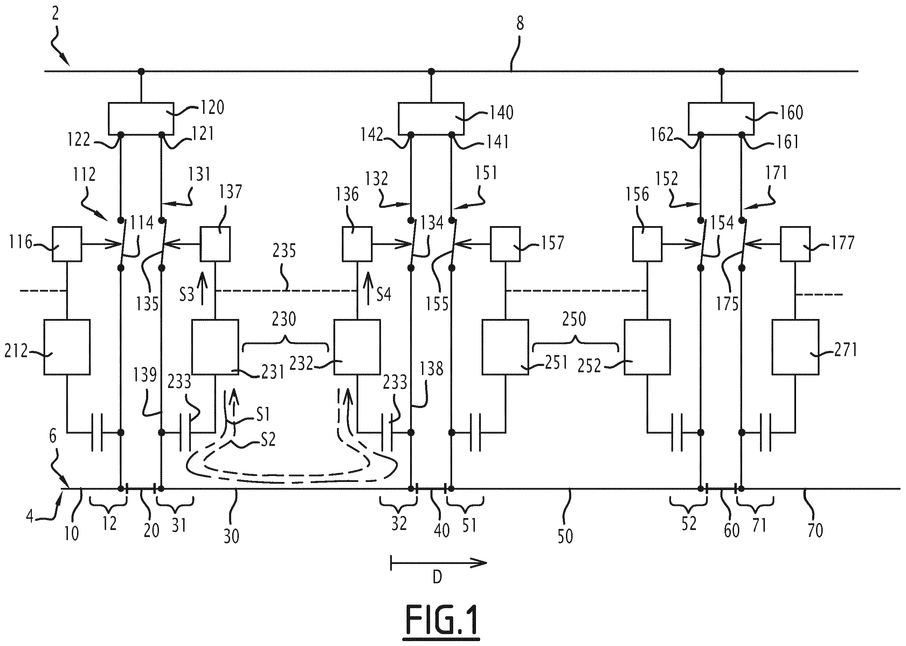

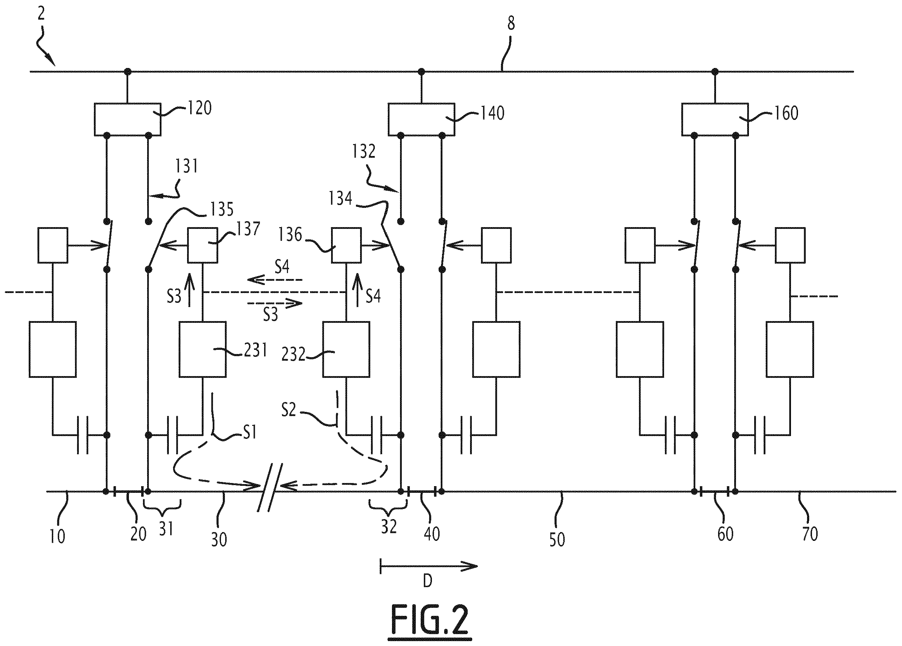

Les figures 1 et 2 représentent un système d'alimentation 2 d'une ligne aérienne de contact 4.

Il s'agit par exemple d'une ligne arienne de contact 4 disposée à l'aplomb d'une voie ferrée, le long de laquelle circule des véhicules électriques guidés. Chaque véhicule est équipé d'un pantographe, monté en toiture, propre à venir en contact de la ligne 4, portée à un potentiel élevé, pour capter la puissance électrique nécessaire à sa propulsion.

Dans le premier mode de réalisation des figures 1 et 2, la ligne 4 comporte un seul fil de contact 6.

Le fil 6 est constitué d'une pluralité de sections conductrices, séparées les unes des autres par des sections isolantes. Sur les figures 1 et 2, les sections conductrices 10, 30, 50 et 70 sont isolées par des sections isolantes 20, 40 et 60.

Plus particulièrement, la section conductrice 30 intermédiaire est séparée d'une section conductrice 10 amont par l'intermédiaire d'une section isolante 20 et d'une section conductrice 50 aval, par une section isolante 40.

Les qualificatifs d'amont et d'aval sont relatifs à une direction D, arbitraire, de la voie ferrée au-dessus de laquelle le fil 6 est tendu.

Le système 2 comporte un réseau 8 d'alimentation haute tension, qui est connecté à un réseau de transport électrique appartenant à un opérateur fournisseur de courant. Le réseau 8 est par exemple parcouru par un courant alternatif dont la tension utile est élevée, typiquement de 20 000 V.

Le système 2 comporte une pluralité de sous-stations d'alimentation, identiques entre elles et connectées au réseau 8.

Sur la figure 1, des sous-stations 120, 140 et 160 sont représentées.

Une sous-station a pour fonction de convertir le courant alternatif haute tension du réseau 8 en un courant continu basse tension, typiquement de 750 V.

L'alimentation de chaque section conductrice du fil 6 est réalisée en connectant une extrémité amont de cette section conductrice à une sous-station amont et une extrémité aval de cette section conductrice à une sous-station aval.

Ainsi, par exemple, l'extrémité amont 31 de la section 30 est connectée à une borne de sortie 121 de la sous-station amont 120, tandis que l'extrémité aval 32 de la section 30 est connectée à une borne de sortie 142 de la sous-station aval 140.

La sous-station amont 120 comporte une autre borne de sortie 122 connectée à l'extrémité aval 12 de la section conductrice 10. La sous-station aval 140 comporte une autre borne de sortie 141 connectée à l'extrémité amont 51 de la section conductrice 50.

Une branche de connexion entre une sous-station et une section conductrice comporte, en série, depuis la borne de sortie de la sous-station vers l'extrémité de la section conductrice considérée, un moyen d'isolation de la sous-station, tel qu'un interrupteur commandé, contrôlé par un circuit de commande, et un fil de liaison relié à l'extrémité de la section conductrice.

Ainsi, la branche 131 entre la sous-station 120 et l'extrémité aval 31 de la section conductrice 30 comporte, depuis la borne 121, un interrupteur commandé 135, qui est contrôlé par un circuit de commande 137, et un fil de liaison 139 connecté électriquement à l'extrémité aval 31 de la section conductrice 30.

De manière similaire, à l'autre extrémité 32 de la section conductrice 30, la branche 132 comporte, depuis la borne 142 de la sous-station 140, un interrupteur commandé 134, qui est contrôlé par un circuit de commande 136, et un fil de liaison 138 connecté à l'extrémité 32 de la section conductrice 30.

Des descriptions similaires pourraient être faites des branches 112, 151, 152 et 171 représentées sur les figures 1 et 2.

Pour détecter la rupture du fil conducteur 6, le système 2 est équipé d'une pluralité de dispositifs de détection. Chaque dispositif de détection est dédié à la surveillance d'une section conductrice associée. Ainsi, par exemple, le système 2 comporte un dispositif de détection 230 pour déterminer, à chaque instant, l'intégrité de la section conductrice 30.

Chaque dispositif de détection comporte une paire de modules d'émission/réception disposés à chaque extrémité de la section conductrice associée. Le dispositif 230 comporte ainsi un module d'émission/réception amont 231 du côté de l'extrémité amont 31 de la section conductrice 30 associée, et un module d'émission/réception aval 232 du côté de l'extrémité aval 32 de la section conductrice 30 associée.

Un module d'émission/réception est couplé, par l'intermédiaire d'un condensateur, au fil de liaison de la branche connectée à l'extrémité correspondante de la section conductrice associée. Par ailleurs, un module d'émission/réception est relié, via une ligne de commande, au circuit de commande de l'interrupteur de la branche connectée à l'extrémité correspondante.

Ainsi, dans notre exemple, le module d'émission/réception amont 231 est couplé, via un condensateur 233, au fil de liaison 139 connecté à l'extrémité amont 31 de la section conductrice 30. Il est par ailleurs relié, par une ligne de commande, au circuit de commande 137 de l'interrupteur amont 135.

De manière similaire, le module d'émission/réception aval 232 est couplé, via un condensateur 233, au fil de liaison 138 connecté à l'extrémité aval 32 de la section conductrice 30. Il est relié, par une ligne de commande, au circuit de commande 136 de l'interrupteur aval 134.

Un module d'émission/réception comporte un émetteur propre à générer périodiquement un signal caractéristique et à le transmettre le long de la section conductrice associée.

Le signal caractéristique est un signal en courant, présentant une fréquence caractéristique f0, par exemple dans la gamme de 100 à 2000 Hz.

Le signal caractéristique est émis de manière permanente.

Un module d'émission/réception comporte un récepteur propre à mesurer le courant sur le fil de liaison auquel il est couplé et à le filtrer. Le filtre du récepteur d'un module d'émission/réception est du type filtre passe bande centré sur la fréquence f0.

En sortie du filtre, le récepteur comporte un comparateur propre à comparer le signal filtré avec un seuil de référence. Lorsque le signal filtré est supérieur ou égal à ce seuil, le comparateur génère un signal d'état de valeur « 1 ». Lorsque le signal filtré est inférieur à ce seuil, le comparateur génère un signal d'état de valeur « 0 ».

En sortie du récepteur, le signal d'état est appliqué, via la ligne de commande, au circuit de commande de l'interrupteur correspondant.

Ainsi, par exemple, le module amont 231 émet de manière permanente un signal caractéristique S1. Grâce au condensateur 233, le signal S1 est appliqué à l'extrémité 31 en superposition du courant d'alimentation appliqué à cette même extrémité par la sous-station aval 120.

Lorsque la section conductrice 30 est intègre, comme cela est représenté sur la figure 1, le signal S1 se propage jusqu'à l'extrémité aval 32 de la section conductrice 30 et le fil de liaison 138.

Là, le récepteur du module aval 232 extrait du courant mesuré sur le fil de liaison 138, le signal caractéristique S1. Le comparateur du récepteur du module 232 maintient alors le signal d'état S4 à la valeur « 1 » et l'applique au circuit de commande 136.

De manière symétrique, le module aval 232 émet périodiquement un signal caractéristique S2. Grâce au condensateur 233, le signal S2 est appliqué à l'extrémité 32 en superposition du courant d'alimentation appliqué à cette même extrémité par la sous-station aval 140.

Lorsque la section conductrice 30 est intègre, le signal S2 se propage jusqu'à l'extrémité amont 31 et le fil de liaison 139.

Le récepteur du module amont 231 extrait du courant mesuré sur le fil de liaison 139, le signal caractéristique S2. Le comparateur du récepteur du module amont 231 maintient alors le signal d'état S3 à la valeur « 1 » et l'applique au circuit de commande 137 de l'interrupteur 135.

En revanche, lorsque la section conductrice 30 est rompu, comme cela est représenté sur la figure 2, le signal caractéristique S1 émis par le module amont 231, respectivement S2 émis par le module aval 232, n'arrive pas jusqu'au récepteur de l'autre module, c'est-à-dire le module aval 232, respectivement le module amont 231.

Le comparateur du récepteur du module aval 232 ne détectant plus le signal S1 bascule alors la valeur du signal d'état S4 à la valeur « 0 ».

De manière symétrique, et sensiblement au même instant, le comparateur du récepteur du module amont 231 ne détectant plus le signal S2 bascule la valeur du signal d'état S3 à la valeur « 0 ».

Un circuit de commande, tel que les circuits 137 et 136, est un circuit logique propre à prendre en compte différentes contraintes, exprimées sous la forme des différents signaux d'état qui lui sont appliqués, pour placer l'interrupteur qu'il contrôle dans l'état ouvert ou fermé.

En particulier, lors d'un changement d'état du signal d'état provenant d'un module d'émission/réception, la valeur du signal d'état basculant de « 1 » à « 0 », le circuit de commande actionne en ouverture l'interrupteur qu'il commande de manière à interrompre l'alimentation entre la sous-station et la section conductrice correspondante.

Ainsi, dès que la section conductrice 30 est rompue, le signal caractéristique S1 n'est plus reçu par le module aval 232, qui bascule la valeur du signal d'état S4 de « 1 » à « 0 ». En conséquence, le circuit de commande 136 actionne en ouverture l'interrupteur 134. La branche 132 est ouverte et la section 30 est isolée de la sous-station 140 aval.

De manière symétrique, le signal caractéristique S2 n'est plus reçu par le module aval 231, qui bascule la valeur du signal d'état de « 1 » à « 0 ». En conséquence, le circuit de commande 137 actionne en ouverture l'interrupteur 135. La branche 131 est ouverte et la section 30 est isolée de la sous-station 120 amont.

En conséquence, la section 30 n'est plus alimentée. Elle ne présente donc plus de risque pour les installations et les personnes situées à proximité.

Dans une variante de réalisation du premier mode de réalisation, chaque circuit de commande 137, 136, est relié non seulement au module d'émission/réception situé de son côté de la section conductrice surveillée, mais également au module d'émission/réception situé du côté opposé.

Cela est représenté sur les figures 1 et 2 par la liaison de commande 235, représentée en traits interrompus, entre les liaisons de commande issues du module amont 231 et du module aval 232.

Ainsi, dans cette variante, un circuit de commande, tel que le circuit de commande 137 amont, peut prendre en compte non seulement le signal d'état S3 émis par le module 231 amont, mais également le signal d'état S4 généré par le module 232 aval. Symétriquement, le circuit de commande 136 aval est capable de prendre en compte non seulement le signal d'état S4 émis par le module 232 aval, mais également le signal d'état S3 généré par le module 231 amont.

Un circuit de commande est par exemple configuré pour ouvrir l'interrupteur qu'il commande dès que l'un des signaux d'état qu'il reçoit change de niveau. Ceci permet d'accroitre la réactivité temporelle du système 2 et d'isoler rapidement la section conductrice défectueuse dès la détection de la rupture du fil de contact par l'un ou l'autre des deux modules du dispositif de détection.

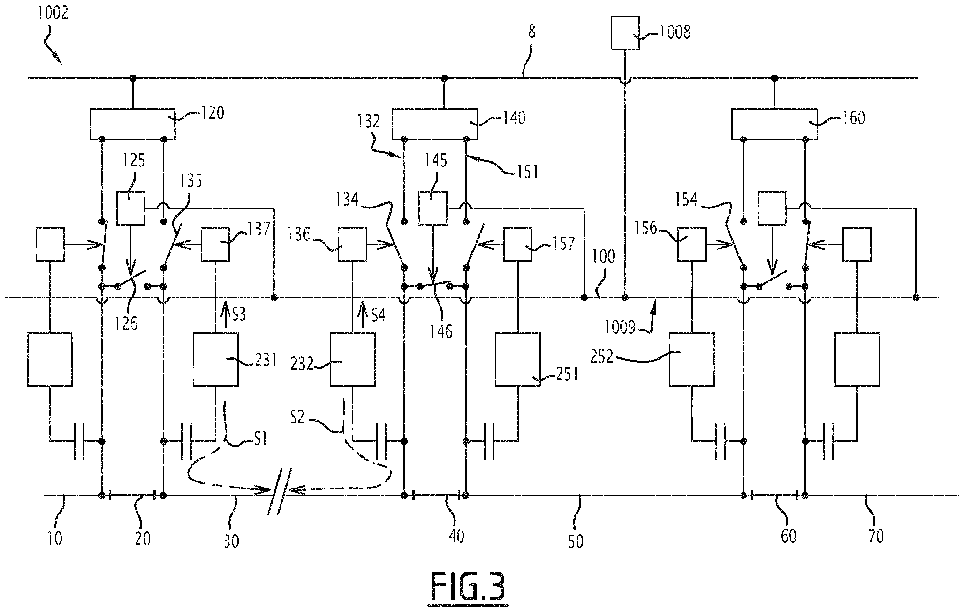

Sur la figure 3, est représenté un seconde mode de réalisation d'un système d'alimentation. Sur cette figure, les chiffres de référence utilisés pour identifier un composant sont les mêmes que ceux utilisés pour identifier ce même composant dans les figures 1 et 2.

Ce système 1002 permet de connecter électriquement deux sections conductrices successives en cas de dysfonctionnement de la sous-station d'alimentation qui leur est commune. Par exemple, en cas de dysfonctionnement de la sous-station 140, un circuit de commande 145 ferme un interrupteur 146 de manière à connecter entre eux les fils de liaison des branches 132 et 151, c'est-à-dire de connecter électriquement les sections conductrices 30 et 50 entre elles. La sous-station 140 est ainsi contournée.

Le groupe constitué des sections conductrices connectées entre elles, est alimenté par une sous-station amont et une sous-station aval, les sous-stations 120 et 160 sur la figure 3.

Dans le système 1002, les circuits de commande des différents interrupteurs sont connectés à un réseau 1009. Les signaux d'état relatifs à la détection par un module d'émission/réception de la section conductrice associée, ainsi que les signaux d'état relatifs à l'état des sous-stations peuvent alors être propagés et pris en compte par un circuit de commande distant.

Ainsi, lors de la rupture de la section conductrice 30, le module d'émission/réception 232 aval ne recevant plus le signal S1 du module d'émission/réception 231 amont, bascule la valeur du signal d'état S4 de la valeur « 1 » à la valeur « 0 ». Ce signal d'état S4 est propagé le long du réseau 1009 vers le circuit de commande 156 de commande de l'interrupteur 154.

Le circuit 156 est configuré pour prendre en compte le changement de valeur du signal d'état S4 dès lors que le signal d'état du circuit 145 indique que l'interrupteur 146 de contournement de la sous-station 140 est fermé. En conséquence, le circuit 156 actionne en ouverture l'interrupteur 154.

Simultanément, le module d'émission/réception 231 amont ne recevant plus le signal S2 du module d'émission/réception 232 aval, bascule la valeur du signal d'état S3 de la valeur « 1 » à la valeur « 0 ». Ce signal d'état S3 est transmis sur le réseau 1009.

Le circuit 137 est configuré pour prendre en compte le changement de valeur du signal d'état S3 dès lors que le signal d'état du circuit 125 indique que l'interrupteur 126 de contournement de la sous-station 120 est ouvert. En conséquence, le circuit 137 actionne en ouverture l'interrupteur 135.

En conséquence, dès qu'une section conductrice d'un groupe de sections conductrices est rompue, l'ensemble du groupe de sections conductrices est isolé des sous-stations amont et aval d'alimentation des sections de ce groupe.

Dans une variante, qui n'est pas spécifique à ce second mode de réalisation, un central de contrôle 1008 est propre à collecter les signaux d'état circulant sur le réseau 1009 pour tenir à jour une représentation du système 1002, permettant par exemple à un opérateur de suivre l'état instantané du système 1002. Au travers de ce central, l'opérateur peut transmettre des signaux d'état vers tel ou tel circuit de commande, par exemple pour remettre dans un état par défaut l'interrupteur commandé par ce circuit de commande.

On peut aussi ajouter qu'au moyen du central de contrôle 1008 il est possible de connaitre la localisation de la panne du type « rupture de contact de la ligne » et ainsi faciliter la maintenance.

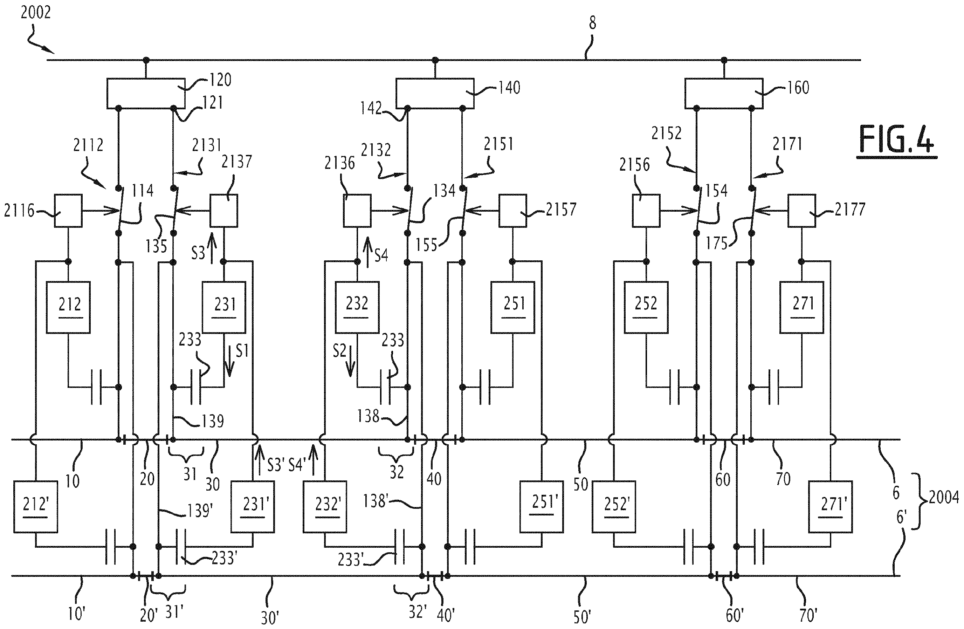

A la figure 4, est représenté un troisième mode de réalisation d'un système d'alimentation 2006 dédié au cas d'une ligne aérienne de contact 2004 comportant deux fils de contact.

Sur cette figure, les chiffres de référence utilisés pour identifier un composant identique à un composant de la figure 1 sont les mêmes que ceux utilisés pour identifier ce composant identique dans la figure 1. Les chiffres de référence utilisés pour identifier un composant identique à un composant de la figure 1 mais associé au second fil sont les mêmes que ceux utilisés pour identifier ce composant identique dans la figure 1, mais primé. Enfin, les chiffres de référence utilisés pour identifier un composant similaire à un composant de la figure 1 sont les mêmes que ceux utilisés pour identifier ce composant similaire dans la figure 1, mais augmenté de deux mille.

La ligne aérienne de contact 2004 comprend deux fils de contact 6 et 6', qui sont disposés parallèlement au-dessus de la voie. La subdivision en sections conductrices et isolantes de chacun des fils est spatialement identique.

Une sous-station est connectée en parallèle à l'extrémité de la section conductrice du premier fil 6 et à l'extrémité de la section conductrice du second fil 6'. De préférence, deux fils de liaison, tels que les fils 139 et 139', sont reliés à l'interrupteur commandé, tel que l'interrupteur 135, de la branche considérée, telle que la branche 2131.

Chaque fil de liaison est couplé à un module d'émission/réception propre à émettre et à recevoir un signal caractéristique le long de la section conductrice associée, afin de détecter toute discontinuité dans la propagation des signaux caractéristiques.

Dans ce troisième mode de réalisation, un circuit de commande d'un interrupteur prend en compte le signal d'état émis par chacun des modules d'émission/réception couplés aux fils de liaison de cette branche. Par exemple, le circuit de commande 2137 de la branche 2131 prend en compte le signal d'état S3 généré par le module 231 ainsi que le signal d'état S3' généré par le module 231'.

Dès que l'un des deux signaux d'état change de niveau, le circuit de commande est propre à commander en ouverture l'interrupteur correspondant.

L'ouverture de l'interrupteur permet d'isoler les deux sections conductrices, c'est-à-dire à la fois la section conductrice pour laquelle une discontinuité a été détectée, mais également la section conductrice de l'autre fil, disposée en parallèle, de manière à assurer la sécurité de l'installation.

Dans ce troisième mode de réalisation, les circuits de commande des interrupteurs sont connectés les uns aux autres pour échanger des signaux d'état. Leurs logiques sont alors adaptées pour prendre en considération ces signaux d'état de manière appropriée.

Comme dans le second mode de réalisation, des moyens peuvent être mis en œ uvre pour permettre la connexion électrique de deux sections conductrices successives d'un même fil, de manière à contourner une sous-station, par exemple défectueuse.

## Revendications

1. Système d'alimentation (2) d'une ligne aérienne de contact (4), ladite ligne comportant au moins un fil de contact (6) constitué d'une pluralité de sections conductrices (10, 30, 50, 70) séparées les unes des autres par des sections isolantes (20, 40, 60), le système comportant une pluralité de sous-stations (120, 140, 160) d'alimentation électrique, chaque section conductrice étant connectée, du côté d'une extrémité amont de ladite section conductrice, à une sous-station amont par l'intermédiaire d'un interrupteur commandé amont (135, 155, 175) et, du côté d'une extrémité aval de ladite section conductrice, à une sous-station aval par l'intermédiaire d'un interrupteur commandé aval (114, 134, 154), chaque interrupteur commandé étant actionné par un circuit de commande correspondant,
le système d'alimentation (2) comportant, en outre, un dispositif de détection (230, 250) associé à une section conductrice (30, 50) à surveiller et comportant un moyen d'émission propre à appliquer un signal caractéristique (S1, S2) à une extrémité parmi l'extrémité amont et l'extrémité aval de ladite section conductrice et un moyen de réception propre à recevoir le signal caractéristique à l'autre extrémité de ladite section conductrice, le moyen de réception étant propre à modifier la valeur d'un signal d'état (S3, S4) et à l'appliquer au moins à un circuit de commande d'actionnement en ouverture de l'interrupteur aval et/ou de l'interrupteur amont,
le dispositif de détection d'une section conductrice associée comportant un module d'émission/réception amont (231) couplé à l'extrémité amont (31) et un module d'émission/réception aval (232) couplé à l'extrémité aval (32) de ladite section conductrice (30),
le module d'émission/réception amont comportant un moyen d'émission amont propre à appliquer un signal caractéristique (S1) à l'extrémité amont,
le module d'émission/réception aval comportant un moyen d'émission aval propre à appliquer un signal caractéristique (S2) à l'extrémité aval,
le module d'émission/réception amont comportant un moyen de réception amont propre à recevoir le signal caractéristique du module d'émission/réception aval et à modifier la valeur d'un signal d'état amont (S3) appliqué à un circuit de commande amont (137) pour actionner en ouverture l'interrupteur amont (135),
le module d'émission/réception aval comportant un moyen de réception aval propre à recevoir le signal caractéristique du module d'émission/réception amont et à modifier la valeur d'un signal d'état aval (S4) appliqué à un circuit de commande aval (136) pour actionner en ouverture l'interrupteur aval (134),
**caractérisé en ce que** le système d'alimentation (2) comporte en outre un interrupteur commandé (146) de contournement d'une sous-station (140) permettant, dans l'état fermé, de connecter entre elles deux sections conductrices (30, 50) successives, le signal d'état modifié par au moins l'un des modules d'émission/réception aval ou amont (231, 232 ; 251, 252) associé à une première section conductrice étant transmis à un circuit de commande (137, 136, 145, 156) d'un interrupteur de connexion de la seconde section conductrice à une autre sous-station (120, 160).

2. Système selon la revendication 1, dans lequel le module d'émission/réception amont (231) applique le signal d'état (S3) au circuit de commande aval (136) auquel il est relié par une liaison de commande (235) adaptée, et en ce que le module d'émission/réception aval (232) applique le signal d'état (S4) au circuit de commande amont (137) auquel il est relié par la liaison de commande (235) adaptée.

3. Système selon la revendication 1 ou la revendication 2, dans lequel ledit signal caractéristique (S1, S2) appliqué par lesdits modules d'émission/réception est un courant, les modules d'émission/réception aval et amont étant couplés à la section conductrice à surveiller par l'intermédiaire d'un condensateur (233) de manière à superposer ledit signal caractéristique au courant d'alimentation de ladite section conductrice (30).

4. Système selon la revendication 3, dans lequel chaque signal caractéristique (S1, S2) est modulé en fréquence à une fréquence caractéristique (f0).

5. Système selon la revendication 4, dans lequel le moyen de réception de chacun des modules d'émission/réception aval et amont comporte un filtre passe bande centré sur la fréquence caractéristique.

6. Système selon l'une quelconque des revendications 1 à 5, comportant un central de contrôle (1008) propre à collecter les signaux d'état appliqués aux différents circuits de commande amont et aval du système d'alimentation (1002) pour tenir à jour une représentation dudit système.

7. Système selon l'une quelconque des revendications 1 à 6, pour une ligne aérienne de contact comportant un premier et un second fils de contact (6, 6'), deux sections conductrices (30, 30') appartenant respectivement au premier et au second fils et disposées parallèlement l'une de l'autre étant connectées en parallèle entre une borne de sortie (121) d'une sous-station amont (120) et une borne de sortie (142) d'une sous-station aval (140), le système (2002) comportant un dispositif de détection (231, 232 ; 231', 232') pour chacune desdites deux sections conductrices.

8. Système selon la revendication 7, dans lequel une extrémité amont (31, 31'), respectivement aval (32, 32') de chacune desdites deux sections conductrices (30, 30'), sont connectées à un interrupteur commandé (135) amont commun, respectivement à un interrupteur commandé (134) aval commun.

## Patentansprüche

1. Stromversorgungssystem (2) für eine Oberleitung (4), wobei die Leitung mindestens einen Fahrdraht (6) aufweist, der aus einer Vielzahl von leitenden Abschnitten (10, 30, 50, 70) besteht, die durch Isolierabschnitte (20, 40, 60) voneinander getrennt sind, wobei das System eine Vielzahl von Unterstationen (120, 140, 160) zur Stromversorgung aufweist, wobei jeder leitende Abschnitt auf der Seite eines stromaufwärts gelegenen Endes des leitenden Abschnitts über einen stromaufwärts gelegenen gesteuerten Schalter (135, 155, 175) mit einer stromaufwärts gelegenen Unterstation verbunden ist und auf der Seite eines stromabwärts gelegenen Endes des leitenden Abschnitts über einen stromabwärts gelegenen gesteuerten Schalter (114, 134, 154) mit einer stromabwärts gelegenen Unterstation verbunden ist, wobei jeder gesteuerte Schalter durch einen entsprechenden Steuerschaltung betätigt wird,
wobei das Stromversorgungssystem (2) ferner eine Detektionsvorrichtung (230, 250) aufweist, die einem zu überwachenden leitenden Abschnitt (30, 50) zugeordnet ist, und Sendemittel, die zum Anlegen eines charakteristischen Signals (S1, S2) an ein Ende von dem stromaufwärts gelegenen Ende und dem stromabwärts gelegenen Ende des leitenden Abschnitts geeignet sind, und eine Empfangseinrichtung aufweist, die geeignet ist, das charakteristische Signal am anderen Ende des leitenden Abschnitts zu empfangen, wobei die Empfangseinrichtung geeignet ist, den Wert eines Statussignals (S3, S4) zu ändern und es auf mindestens einen Schaltkreis zum Befehlen des Öffnens des stromabwärts gelegenen Schalters und/oder des stromaufwärts gelegenen Schalters anzuwenden,
wobei die Detektionsvorrichtung eines zugeordneten leitenden Abschnitts ein stromaufwärts gelegenes Sende-/Empfangsmodul (231), das mit dem stromaufwärts gelegenen Ende (31) gekoppelt ist, und ein stromabwärts gelegenes Sende-/Empfangsmodul (232), das mit dem stromabwärts gelegenen Ende (32) des leitenden Abschnitts (30) gekoppelt ist, aufweist,
wobei das stromaufwärts gelegene Sende-/Empfangsmodul stromaufwärts gelegene Sendemittel aufweist, die geeignet sind, ein charakteristisches Signal (S1) an das stromaufwärts gelegene Ende anzulegen,
wobei das stromabwärts gelegene Sende-/Empfangsmodul stromabwärts gelegene Sendemittel aufweist, die geeignet sind, ein charakteristisches Signal (S2) an das stromabwärts gelegene Ende anzulegen,
wobei das stromaufwärts gelegene Sende-/Empfangsmodul stromaufwärts gelegene Empfangsmittel aufweist, die geeignet sind, um das charakteristische Signal des stromabwärts gelegenen Sende-/Empfangsmoduls zu empfangen und den Wert eines stromaufwärts gelegenen Statussignals (S3) zu ändern, das an eine stromaufwärts gelegene Steuerschaltung (137) angelegt ist, um den stromaufwärts gelegenen Schalter (135) zu öffnen,
wobei das stromabwärts gelegene Sende-/Empfangsmodul stromabwärts gelegene Empfangsmittel aufweist, die geeignet sind, um das charakteristische Signal des stromaufwärts gelegenen Sende-/Empfangsmoduls zu empfangen und den Wert eines stromabwärts gelegenen Statussignals (S4) zu ändern, das an eine stromabwärts gelegene Steuerschaltung (136) angelegt ist, um den stromabwärts gelegenen angeordneten Schalter (134) zu öffnen,
dadurch charakterisiert, dass es ferner einen gesteuerten Schalter (146) zum Umgehen einer Unterstation (140) aufweist, der es ermöglicht, im geschlossenen Zustand zwei aufeinanderfolgende leitende Abschnitte (30, 50) miteinander zu verbinden, wobei das durch mindestens eines der stromabwärts gelegenen oder stromaufwärts gelegenen Sende-/Empfangsmodule (231, 232 ; 251, 252), das einem ersten leitenden Abschnitt zugeordnet ist, modifizierte Zustandssignal an eine Steuerschaltung (137, 136, 145, 156) eines Verbindungsschalters des zweiten leitenden Abschnitts mit einer anderen Unterstation (120, 160) übertragen wird.

2. System nach Anspruch 1, wobei das stromaufwärts gelegene Sende-/Empfangsmodul (231) das Statussignal (S3) an die stromabwärts gelegene Steuerschaltung (136) anlegt, mit der es durch eine angepasste Steuerverbindung (235) verbunden ist, und dadurch, dass das stromabwärts gelegene Sende-/Empfangsmodul (232) das Statussignal (S4) an die stromaufwärts gelegene Steuerschaltung (137) anlegt, mit der es durch die angepasste Steuerverbindung (235) verbunden ist.

3. System nach Anspruch 1 oder Anspruch 2, wobei das von den Sende-/Empfangsmodulen angelegte charakteristische Signal (S1, S2) ein Strom ist, wobei die stromabwärts gelegenen und stromaufwärts gelegenen Sende-/Empfangsmodule mit dem zu überwachenden leitenden Abschnitt über einen Kondensator (233) gekoppelt sind, um das charakteristische Signal dem Versorgungsstrom des leitenden Abschnitts (30) zu überlagern.

4. System nach Anspruch 3, bei dem jedes charakteristische Signal (S1, S2) auf eine charakteristische Frequenz (f0) frequenzmoduliert ist.

5. System nach Anspruch 4, worin die Empfangsmittel jedes der stromabwärts und stromaufwärts gelegenen Sende-/Empfangsmodule einen Bandpassfilter beinhalten, der auf die charakteristische Frequenz zentriert ist.

6. System nach einem der Ansprüche 1 bis 5, aufweisend eine Steuerzentrale (1008) zum Sammeln der Statussignale, die an die verschiedenen stromaufwärts gelegenen und stromabwärts gelegenen Steuerschaltungen des Stromversorgungssystems (1002) angelegt werden, um eine aktuelle Repräsentation des Systems zu erhalten.

7. System nach einem der Ansprüche 1 bis 6 für eine Oberleitung mit ersten und zweiten Fahrdrähten (6, 6'), wobei zwei zu dem ersten bzw. zu dem zweiten Draht gehörende und parallel zueinander angeordnete leitende Abschnitte (30, 30') parallel zwischen einem Ausgangsanschluss (121) einer stromaufwärts gelegenen Unterstation (120) und einem Ausgangsanschluss (142) einer stromabwärts gelegenen Unterstation (140) geschaltet sind, wobei das System (2002) eine Detektionsvorrichtung (231, 232 ; 231', 232') für jeden der beiden leitenden Abschnitte aufweist.

8. System nach Anspruch 7, wobei ein stromaufwärts (31, 31') bzw. stromabwärts (32, 32') gelegenes Ende (32, 32') jedes der beiden leitenden Abschnitte (30, 30') mit einem gemeinsamen stromaufwärts gelegenen gesteuerten Schalter (135) bzw. einem gemeinsamen stromabwärts gelegenen gesteuerten Schalter (134) verbunden ist.

## Claims

1. A system (2) for powering an overhead contact line (4), said overhead contact line including at least one contact wire (6) consisting of a plurality of conductive sections (10, 30, 50, 70) separated from each other by insulating sections (20, 40, 60), the system including a plurality of sub-stations (120, 140, 160) for supplying electric power, each conductive section being connected, on the side of an upstream end of said conductive section, to an upstream sub-station via an upstream controlled switch (135, 155, 175) and, on the side of a downstream end of said conductive section, to a downstream sub-station via a downstream controlled switch (114, 134, 154), each controlled switch being actuated by a corresponding control circuit,
the system (2) further including a detection device (230, 250) associated with a conductive section (30, 50) to be monitored and including a transmission means to apply a characteristic signal (S1, S2) to an end from among the upstream end and the downstream end of said conductive section and a receiving means to receive the characteristic signal at the other end of said conductive section, the receiving means modifying the value of a state signal (S3, S4) and applying it at least to a circuit for controlling the actuation of the opening of the downstream switch and/or of the upstream switch,
the detection device of an associated conductive section including an upstream transceiver module (231) coupled with the upstream end (31) and a downstream transceiver module (232) coupled with the downstream end (32) of said conductive section (30),
the upstream transceiver module including an upstream transmission means to apply a characteristic signal (S1) to the upstream end,
the downstream transceiver module including a downstream transmission means to apply a characteristic signal (S2) to the downstream end,
the upstream transceiver module including an upstream receiving means to receive the characteristic signal of the downstream transceiver module and to modify the value of an upstream state signal (S3) applied to an upstream control circuit (137) for actuating the opening of the upstream switch (135),
the downstream transceiver module including a downstream receiving means to receive the characteristic signal of the upstream transceiver module and to modify the value of a downstream state signal (S4) applied to a downstream control circuit (136) for actuating the opening of the downstream switch (134),
**characterised in that** the system further includes a controlled switch (146) for circumventing a sub-station (140) allowing, in the closed state, the connection together of two successive conductive sections (30, 50), the state signal modified by at least one of the downstream or upstream transceiver modules (231, 232 ; 251, 252) associated with a first conductive section being transmitted to a control circuit (137, 136, 145, 156) of a switch for connecting the second conductive section to another sub-station (120, 160).

2. The system according to claim 1, wherein the upstream transceiver module (231) applies the state signal (S3) to the downstream control circuit (136) to which it is connected through an adapted control link (235), and in that the downstream transceiver module (232) applies the state signal (S4) to the upstream control circuit (137) to which it is connected through the adapted control link (235).

3. The system according to claim 1 or claim 2, wherein said characteristic signal (S1, S2) applied by said transceiver modules is a current, the downstream and upstream transceiver modules being coupled with the conductive section to be monitored via a capacitor (233) so as to superpose said characteristic signal to the power supply current of said conductive section (30).

4. The system according to claim 3, wherein each characteristic signal (S1, S2) is frequency-modulated at a characteristic frequency (f0).

5. The system according to claim 4, wherein the receiving means of each of the downstream and upstream transceiver modules includes a band pass filter centered on the characteristic frequency.

6. The system according to any of claims 1 to 5, including a control central unit (1008) able to collect the state signals applied to the different upstream and downstream control circuits of the power supply system (1002) in order to keep updated a representation of said system.

7. The system according to any of claims 1 to 6, for an overhead contact line including first and second contact wires (6, 6'), two conductive sections (30, 30') respectively belonging to the first and second wires and positioned parallel to each other, being connected in parallel between an output terminal (121) of an upstream sub-station (120) and an output terminal (142) of a downstream sub-station (140), the system (2002) including a detection device (231, 232; 231', 232') for each of said two conductive sections.

8. The system according to claim 7, wherein an upstream (31, 31'), respectively downstream (32, 32') end of each of said two conductive sections (30, 30'), are connected to a common upstream controlled switch (135), respectively to a common downstream controlled switch (134).
